# EUROPÄISCHE PATENTSCHRIFT

(11) **EP 2 992 121 B1**
(45) Veröffentlichungstag und Bekanntmachung des Hinweises auf die Patenterteilung: **19.06.2019**
(21) Anmeldenummer: 14720969.6
(22) Anmeldetag: 30.04.2014
(51) Int. Cl.: C23C 14/06, H01J 37/34, C23C 14/34, C23C 28/00, H01J 37/147, H01J 37/32, C23C 14/32

(54) **VERFAHREN ZUR HERSTELLUNG EINER VERSCHLEISS-SCHUTZSCHICHT UND MIT DEM VERFAHREN HERGESTELLTE VERSCHLEISS-SCHUTZSCHICHT**
METHOD OF PRODUCING AN ANTI-WEAR LAYER AND ANTI-WEAR LAYER PRODUCED BY MEANS OF SAID METHOD
PROCÉDÉ POUR PRODUIRE UNE COUCHE ANTI-USURE ET COUCHE ANTI-USURE OBTENUE A L'AIDE DUDIT PROCÉDÉ

(30) Priorität: 30.04.2013 DE 102013007986
(43) Veröffentlichungstag der Anmeldung: 09.03.2016
(73) Patentinhaber: Fraunhofer-Gesellschaft zur Förderung der angewandten Forschung e.V., 80686 München (DE); H-O-T Härte- Und Oberflächentechnik GmbH & Co. KG, 90425 Nürnberg (DE)
(72) Erfinder: LESON, Andreas, 01328 Dresden (DE); SCHEIBE, Hans-Joachim, 01309 Dresden (DE); BACH, Frank-Peter, 90425 Nürnberg (DE)
(74) Vertreter: Pfenning, Meinig & Partner mbB
(86) Internationale Anmeldenummer: PCT/EP2014/058884
(87) Internationale Veröffentlichungsnummer: WO 2014/177641

(56) Entgegenhaltungen:
- EP-A2- 1 826 810
- WO-A1-2010/020274
- DE-A1-102004 041 235
- DE-A1-102011 003 254
- DE-A1-102011 016 611
- JP-A- 2008 297 477
- H SCHEIBE ET AL: "Laser-induced vacuum arc (Laser Arc) and its application for deposition of hard amorphous carbon films", SURFACE AND COATINGS TECHNOLOGY, Bd. 74-75, 1. Oktober 1995 (1995-10-01), Seiten 813-818, XP055013859, ISSN: 0257-8972, DOI: 10.1016/0257-8972(95)08280-8

## Beschreibung

Die Erfindung betrifft ein Verfahren zur Herstellung von Verschleißschutzschichten, die auf Oberflächen von Bauteilen von Verbrennungskraftmaschinen, die Reibverschleiß ausgesetzt sind, mittels elektrischer Bogenentladung unter Vakuumbedingungen auf der jeweiligen Oberfläche ausgebildet worden sind, und mit dem Verfahren hergestellte Verschleißschutzschichten. Die Verschleißschutzschichten sind dabei aus wasserstrofffreien, tetraedischen amorphem aus sp² und sp³ hybridisiertem Kohlenstoff (ta-C) gebildet. Es hat sich gezeigt, dass diese Art von Schichten, bei denen ein maximaler Wasserstoffgehalt von 1 Atom-%, bevorzugt maximal 0,5 Atom-% noch zulässig sein soll, besonders günstige Verschleiß- und Gleiteigenschaften aufweisen. Es wurde daher vorgeschlagen, diese Schichten auf verschiedensten auf Verschleiß beanspruchten Oberflächen von Bauteilen von Verbrennungskraftmaschinen, wie dies beispielsweise Kolbenringe, Tassenstößel, Nocken von Nockenwellen oder auch Kolbenbolzen sind, einzusetzen.

Dies Schichten weisen eine hohe Härte und daher einen erhöhten Verschleißwiderstand auf. Auch die erreichbaren Reibwerte bei einer wirkenden Gleitbewegung an der Oberfläche eines nicht so beschichteten Grund- oder Gegenkörpers sind gering, so dass sich dies auf den ökonomischen Betrieb und die CO₂-Bilanz vorteilhaft auswirkt.

Solche Schichten können mit verschiedenen PVD-Vakuumbeschichtungsverfahren unter Einsatz einer Graphitkathode hergestellt werden. Dabei hat es sich herausgestellt, dass eine besonders hohe Beschichtungsrate bei Verfahren erreicht werden kann, bei denen elektrische Bogenentladungen zwischen einer Anode oder einer aus Graphit gebildeten Kathode erreichen lassen. Bei diesen Verfahren ist es aber nachteilig, dass bei der Beschichtung größere Partikel oder auch so genannte Droplets gebildet werden, die sich in der Schicht ablagern und die Oberflächeneigenschaften dadurch nachteilig beeinflusst werden, so dass die Oberfläche durch eine Nachbearbeitung eingeebnet werden muss. Dies bereitet bei Schichten, die eine besonders hohe Härte aufweisen, aber erhebliche Probleme, die sich insbesondere bei Mikrohärten oberhalb 5000 HV nachteilig auswirken, da ein extrem hoher Zeitaufwand erforderlich ist, um ausreichend glatte Oberflächen dieser Schichten für ein günstiges Gleitverhalten erhalten zu können.

Für die Ausbildung solcher harten Schichten ist besonders das sogenannte Laser-Arc-Verfahren, bei dem eine elektrische Bogenentladung im Vakuum mittels eines gepulst betriebenen Laserstrahls gezündet und mit dem über die Bogenentladung erhaltenen Plasma der ionisierte Teilchenstrom zu einem Substrat geführt und auf diesem als Schicht die ionisierten Teilchen abgeschieden werden können, geeignet.. Diese Art von Schichten können aber auch bei einem an sich bekannten Verfahren, bei dem eine elektrische Bogenentladung im Vakuum zur Erzeugung des Plasmas benutzt wird, ohne dass die Bogenentladung mit einem Laserstrahl initiiert wird, angewendet werden. Dabei kann die Bogenentladung auf bekannte Art und Weise, entweder allein durch eine ausreichend hohe Spannung zwischen einer Anode und einem als Kathode geschalteten Target gezündet werden und zum anderen besteht die Möglichkeit, die Zündung mittels elektrisch leitender Zündelemente infolge Kurzschluss zu initiieren.

Diese bekannten Verfahren, weisen jedoch den Nachteil auf, dass ihr Plasma relativ reich an Tröpfchen und Partikeln ist.

Um diesem Nachteil entgegenzutreten wurden aber Möglichkeiten vorgeschlagen, um eine sogenannte "Filterung" des Plasmas zur Speicherung von Partikeln durchzuführen. Mehrere Möglichkeiten hierfür sind von B. F. Coll und D. M. Sanders in "Design of Vacuum Arc- Basis Sources"; Surface and Coatings Technology", No. 81 (1996) 42-51 beschrieben. Dabei wird bei diesen bekannten Lösungen davon ausgegangen, dass unter Verwendung magnetischer Felder die ionisierten leichten Bestandteile eines Plasmas abgelenkt werden können und die wesentlich größeren, wegen ihres ungünstigen Ladungs-/Masseverhältnisses, schwerer ablenkbaren Partikel voneinander getrennt werden können. Diese Filteranordnungen haben jedoch einige erhebliche Nachteile:
Der Aufbau dieser Systeme ist sehr komplex und entsprechend teuer. Der Durchmesser der magnetischen Filter und damit der Durchmesser der Beschichtungsfläche ist auf Grund der benötigten kräftigen magnetischen Felder und der dazu benötigten elektrischen Leistungen auf ca. 150 mm begrenzt. Die Beschichtungsrate der Verfahren wird auf ca. 15-20 % im Vergleich zu der ohne Verwendung des magnetischen Filters verringert.

Für Verfahren bei denen elektrische Bogenentladungen zur Beschichtung genutzt werden, ist in DE 10 2006 009 160 A1 der Einsatz einer Absorberelektrode und von Magneten vorgeschlagen worden, um größere Partikel aus einem Plasma zu separieren und damit zu verhindern, dass sich diese in der Beschichtung absetzen und dadurch auch die Oberflächengeometrie nachteilig beeinflusst wird.

Bisher sind jedoch keine Schichten bekannt, die aus wasserstofffreien tetraedischen amorphen aus sp² und sp³ hybridisiertem Kohlenstoff (ta-C) gebildet sind, die gleichzeitig eine erhöhte Härte und dabei sehr gute Gleitreibungseigenschaften aufweisen, und dabei auf Bauteiloberflächen mit einer erhöhten Beschichtungsrate mittels elektrischer Bogenentladungen abgeschieden worden sind, ohne dass eine nachträgliche Oberflächenbearbeitung, die zur Einebnung von Erhebungen und zur Reduzierung der Rauheit führt, durchgeführt werden muss.

So ist aus JP 2008 297477 A ein Element mit geringere Reibung bekannt, das mit einer DLC-Beschichtung versehen ist.

DE 10 2004 041 235 A1 betrifft eine verschleißfeste Beschichtung und ein Verfahren zu ihrer Herstellung.

Eine Anordnung zur Separation von Partikeln aus einem Plasma ist in EP 1 826 810 A2 offenbart.

Von H. Scheibe u.a. sind in "Laser-induced vacuum arc (laser Arc) and its application for deposition of hard amophous carbon Films"; Surface and Coatings Technology; Bd. 74-75: 1. Oktober 1995 (1995-10-1); Seiten 813-818; XP055013859; ISNN: 0257-8972; DOI: 10.1016/0257-8972(95)08280-8 Möglichkeiten zur Ausbildung diamantähnlicher Schichten mit einem Laser-Arc-Verfahren beschrieben.

Ein Gleitsystem ist in DE 10 2011016 611 A1 offenbart.

Eine zur Verringerung der Reibungseffekte und Verbesserung des Verschleißwiderstandes auf einem Bauteil ausgebildete Schicht geht aus WO 2010/020274 A1 hervor.

Aus DE 10 2011 003 254 A1 sind ein Gleitelement mit einer Beschichtung sowie ein Verfahren zu seiner Herstellung bekannt.

Es ist daher Aufgabe der Erfindung eine Verschleißschutzbeschichtung für auf Gleitreibung beanspruchte Oberflächen von Bauteilen von Verbrennungskraftmaschinen zur Verfügung zu stellen, die einen verbesserten Verschleißschutz und gleichzeitig verbesserte Gleiteigenschaften aufweist, wobei die Herstellung mit reduziertem Aufwand und erhöhter Beschichtungsrate mittels elektrischer Bogenentladungen erfolgen kann.

Erfindungsgemäß wird diese Aufgabe mit den Merkmalen des Anspruchs 1 gelöst. Der Anspruch 6 betrifft mit dem Verfahren hergestellte Verschleißschutzschichten. Vorteilhafte Ausgestaltungen und Weiterbildungen der Erfindung können mit Merkmalen, die in untergeordneten Ansprüchen bezeichnet sind, realisiert werden.

Mit dem erfindungsgemäßen Verfahren werden Verschleißschutzschichten auf Oberflächen von Bauteilen von Verbrennungskraftmaschinen, die Reibverschleiß ausgesetzt sind, hergestellt. Dabei wird ein Plasma mittels gepulster Laserbestrahlung sequentiell gezündeter elektrischer Bogenentladungen unter Vakuumbedingungen, bei dem die elektrische Bogenentladung zwischen einer Anode und einer als Kathode aus Graphit betrieben werden, gebildet. Es werden ionisierte Teile des Plasma als Schicht, die aus zumindest annähernd wasserstofffreiem, , tetraedisch amorphen (ta-C), bestehend aus einer Mischung von sp² und sp³ hybrisiertem Kohlenstoff (ta-C gemäß VDI-Richtlinie 2840) gebildet und auf einer Oberfläche mindestens eines Bauteils abgeschieden werden.

Positiv geladenen Ionen des Plasma werden mittels einer Absorberelektrode in Richtung des mindestens einen Bauteils bewegt. Dabei wird an der Anode und der Absorberelektrode zumindest annähernd die gleiche elektrische Spannung angelegt.

Es wird keine mechanische und/oder chemische Nachbearbeitung der beschichteten Oberfläche des mindestens einen Bauteils, die zu einer Glättung der Oberfläche führt, durchgeführt. Eine nachträgliche Glättung der Oberfläche der ausgebildeten Verschleißschutzschicht ist insbesondere durch die Beeinflussung des durch die Anode und die Absorberelektrode fließenden jeweils unterschiedlichen elektrischen Stromes nicht erforderlich.

Vorteilhaft wird das Plasma innerhalb einer Laser-Arc-Kammer gebildet und in eine Vakuumkammer in der das mindestens eine Bauteil angeordnet ist, umgelenkt. Die Laser-Arc-Kammer kann dabei an die Vakuumkammer angeangeflanscht sein. In der Laser-Arc-Kammer wird ebenfalls ein Vakuum eingehalten.

Mittels der Absorberelektrode sollten positiv geladene Ionen des Plasma so umgelenkt werden, dass sie ausgehend von der Kathode nicht auf direktem Weg auf die Oberfläche des mindestens einen Bauteils auftreffen und sich Elektronen aus dem Plasma in Richtung Absorberelektrode bewegen, so dass sie sich möglichst nicht oder mit geringer Anzahl in Richtung zu beschichtender Bauteiloberfläche bewegen.

Mit mindestens einer angeordneter Bogenentladungs- oder Sputterquelle, die in der Vakuumkammer angeordnet ist, kann eine dünne Haftschicht auf dem mindestens einen Bauteil abgeschieden werden.

Vorteilhaft kann eine Absorberelektrode mit mehreren Streifen eingesetzt werden. Zwischen den Streifen können größere Tröpfchen oder Droplets abgeführt werden, so dass sie nicht auf die Oberfläche des mindestens einen Bauteils auftreffen. Eine die Bewegungsrichtung von Tröpfchen herbeiführende Reflexion kann so weitestgehend vermieden werden.

Die erfindungsgemäß hergestellte Verschleißschutzschicht ist auf Oberflächen von Bauteilen von Verbrennungskraftmaschinen, die Reibverschleiß ausgesetzt sind, ausgebildet. Sie sind mittels elektrischer Bogenentladung unter Vakuumbedingungen auf der jeweiligen Oberfläche ausgebildet worden, und sind aus zumindest annähernd wasserstofffreiem, tetraedisch amorphen (ta-C), bestehend aus einer Mischung von sp² und sp³ hybrisiertem Kohlenstoff gebildet. Bevorzugt können sie mit dem bereits angesprochenen Laser-Arc-Verfahren ausgebildet werden.

Die Verschleißschutzschicht weist eine Mikrohärte von mindestens 3500 HV und einen arithmetischen Mittenrauwert Rₐ von 0,1 µm auf. Dabei ist keine nachträgliche mechanische und/oder chemische Oberflächenbearbeitung erforderlich, um diese Rauheitswerte einhalten zu können.

Die erfindungsgemäß hergestellte Verschleißschutzschicht kann dabei vorteilhaft auch eine gemittelte Rautiefe R_{z} von maximal 1,0 µm aufweisen. Die gemittelte Rautiefe R_{z} entspricht dem arithmetischen Mittelwert der Einzelrautiefen aller Messwerte.

Die erfindungsgemäß hergestellte Verschleißschutzschicht sollte eine reduzierte Spitzenhöhe Rₚₖ von maximal 0,35 µm, bevorzugt maximal 0,25 µm aufweisen. Dieser Wert ist insbesondere unter dem Gesichtspunkt einer reduzierten Gleitreibung von Bedeutung und daher vorteilhaft.

Sowohl der arithmetische Mittenrauwert Rₐ, wie auch die beiden anderen Rauheitswerte R_{z} und Rₚₖ können mit dem bekannten Tastschnittverfahren bestimmt werden. Dabei sollte eine Tastspitze, die bevorzugt aus Diamant besteht, und einen kleinen Spitzenradius aufweist, eingesetzt werden.

Besonders günstig ist es, wenn die Verschleißschutzschicht eine Mikrohärte von mindestens 3500 HV, bevorzugt von 4000 HV, weiter bevorzugt von mindestens 5000 HV, besonders bevorzugt von mindestens 5700 HV und ganz besonders bevorzugt von 6000 HV und bevorzugt einen Mittenrauwert Rₐ kleiner 0,08 µm, besonders bevorzugt kleiner 0,05 nm_aufweist, wodurch der Verschleißwiderstand und die Lebensdauer weiter verbessert bzw. erhöht werden können. Für die Härtemessung kann dabei auf ein Gerät "FISCHERSCOPE H100C XYP" der Firma Helmut Fischer GmbH& Co.KG zurückgegriffen werden. Die Prüfkraft sollte so gewählt werden, dass die Eindringtiefe des Indenters maximal 1/10 der Schichtdicke beträgt.

Mit einer erfindungsgemäß hergestellten Verschleißschutzschicht auf Kolbenbolzen kann in einem tribologischen System bestehend aus Gegenkörper Pleuel mit Buchse (Messing) und Kolben aus Aluminium mit einem Schwing-Reib-Verschleiß-Tribometer mit Kolbenbolzenmodul der Firma Optimol Instruments Prüftechnik GmbH ein Reibwert kleiner 0,03, bevorzugt kleiner 0,025 erreicht werden. Dies trifft auf mit Öl geschmierte Versuche auch in einem Temperaturbereich zwischen 100 °C und 130 ° C, wie er für Bauteile von Verbrennungskraftmaschinen typisch ist, zu. Der Reibwert ändert sich über die Lebensdauer eines beschichteten Bauteils nur geringfügig, wobei eine Reduzierung des Reibwertes nach einer kurzen Einlaufzeit erkannt werden konnte.

Die Verschleißrate kann gegenüber konventionellen DLC-Schichten um den Faktor 3 reduziert werden.

Dabei sollte der Anteil an sp³ hybridisiertem Kohlenstoff deutlich oberhalb 40%, bevorzugt oberhalb 50 % liegen.

Außerdem sollten in der Verschleißschutzschicht keine weiteren chemischen Elemente, wie beispielsweise Metalle oder Halogene bzw. Phosphor enthalten sein. Dies trifft auch auf chemische Verbindungen zu. Dazu sollte in der Laser-Arc-Kammer und in der Vakuumkammer ggf. lediglich ein inertes Gas, wie insbesondere Argon und keine Kohlenwasserstoffverbindung enthalten sein.

Die Schichtdicken sollten mindestens 0,5 µm, bevorzugt mindestens 2 µm oder mehr sein.

Vorteilhaft kann auf der zu beschichtenden Oberfläche mindestens eine Haft- und/oder Zwischenschicht ausgebildet worden sein, auf der dann eine erfindungsgemäße Verschleißschutzschicht ausgebildet wird. Hierfür kann beispielsweise eine Chromschicht mit einer Schichtdicke von mindestens 0,1 µm gewählt werden.

Bei der Herstellung kann vorteilhaft eine zylinderförmige Kathode (Target) aus Graphit eingesetzt werden, die während des Prozesses um ihre Längsachse rotiert, so dass die jeweiligen Fußpunkte der elektrischen Bogenentladungen über die gesamte Oberfläche der Kathode verlaufen und dadurch ein geleichmäßiger Abtrag des Kohlenstoffs erreicht werden kann. Bei Zündung von gepulst betriebenen elektrischen Bogenentladungen mittels eines Laserstrahls, kann der Laserstrahl entsprechend ebenfalls gepulst betrieben und ausgelenkt werden, so dass er an verschiedenen vorbestimmten Positionen auf die Oberfläche der Kathode auftrifft und dort infolge des Energieeintrags eine elektrische Bogenentladung bei jedem Laserpuls gezündet werden kann. Die elektrische Spannung zwischen einer Anode und der Kathode wird dabei so gesteuert, dass der Bogen jeweils nach einer vorbestimmten Zeit wieder erlischt, um anschließend an einer anderen Position eine erneute Bogenentladung zu zünden. Die Schichtdicke einer auszubildenden Verschleißschutzschicht kann mittels der Anzahl der ausgenutzten elektrischen Bogenentladungen, bei bekannter Größe einer zu beschichtenden Oberfläche beeinflusst werden. Andere Verfahrensparameter sollten dann jedoch möglichst konstant gehalten werden.

Mit den Parametern elektrischer Strom und elektrische Spannung mit der elektrische Bogenentladungen betrieben werden, deren Zeitdauer, der Pulsfrequenz sowie einer an ein zu beschichtendes Bauteil (Substrat)während des Bogenimpulses anliegenden BIAS-Spannung kann ebenfalls Einfluss auf die auszubildende Schicht genommen werden. Dies betrifft insbesondere den Schichtaufbau und insbesondere die Anteile an sp² und sp³ hybridisiertem Kohlenstoff.

So sollen elektrische Ströme oberhalb 1000 A, bevorzugt oberhalb 1500 A eingesetzt werden und eine Pulsfrequenz zwischen 300 Hz und 600 Hz gewählt werden. Es kann eine BIAS-Spannung im Bereich - 50 V bis - 200 V, bevorzugt im Bereich 100 V an das zu beschichtende Bauteil angelegt werden. So fließt ein elektrischer Strom von 500 A ± 100 A (bevorzugt ± 50 A) durch die Anode und von 1100 A ± 100 A (bevorzugt ± 50 A) durch die Absorberelektrode, wenn elektrische Bogenentladungen gezündet worden sind und betrieben werden. Der Betrieb von elektrischen Bogenentladungen kann mit einer Pulsdauer im Bereich 250 µs bis 600 µs erfolgen. Eine Beendigung der elektrischen Bogenentladungen kann durch Reduzierung der elektrischen Spannung zumindest an der Anode erreicht werden. Eine Zündung von elektrischen Bogenentladungen nach einer gepulst durchgeführten Bestrahlung der Oberfläche der Kathode mit einem auf die Oberfläche gerichteten Laserstrahl kann bei erhöhter elektrischer Spannung erfolgen, die nach Zündung der jeweiligen elektrischen Bogenentladung reduziert wird.

Bei der Beschichtung sollte eine Vorrichtung eingesetzt werden, mit der größere Partikel daran gehindert werden, auf die zu beschichtende Oberfläche aufzutreffen. Dies kann eine Absorberelektrode jeweils allein, sein.

Dabei kann ein Aufbau eingesetzt werden, wie er aus DE 10 2006 009 160 A1 bekannt ist. In diesem Fall wird mindestens ein Permanentmagnetelement eingesetzt, das parallel zur Rotationsachse der Kathode bzw. parallel zur Oberfläche einer Kathode ausgerichtet ist. Zusätzlich ist dabei eine Absorberelektrode vorhanden mit der ein elektrisches Feld ausgebildet ist, durch das mittels der elektrischen Bogenentladung gebildetes Plasma geführt ist. Sowohl mit dem/den Permaentmagnetelement(en), wie auch mit der Absorberelektrode können größere im Plasma enthaltene Partikel in ihrer Bewegung, insbesondere in ihrer Bewegungsrichtung so beeinflusst werden, dass sie nicht auf die zu beschichtende Oberfläche oder dort in einem Winkel auftreffen, der einen Einbau in die Schicht vermeidet. Zusätzlich kann mindestens eine Blende zwischen der zu beschichtenden Oberfläche eines Bauteils und der Kathode angeordnet sein, durch die das die Kohlenstoffionen, die zur Schichtbildung genutzt werden können, enthaltende Plasma in Richtung auf die zu beschichtende Oberfläche geführt wird. Die Absorberelektrode kann dabei in Bewegungsrichtung des Plasma nach einer Blende und/oder Anode angeordnet sein. Ein Permantmagnetelement kann beispielsweise im Schatten einer Blende oder eines Blendenelements angeordnet sein.

Nachfolgend soll die Erfindung beispielhaft näher erläutert werden.

Dabei zeigt:

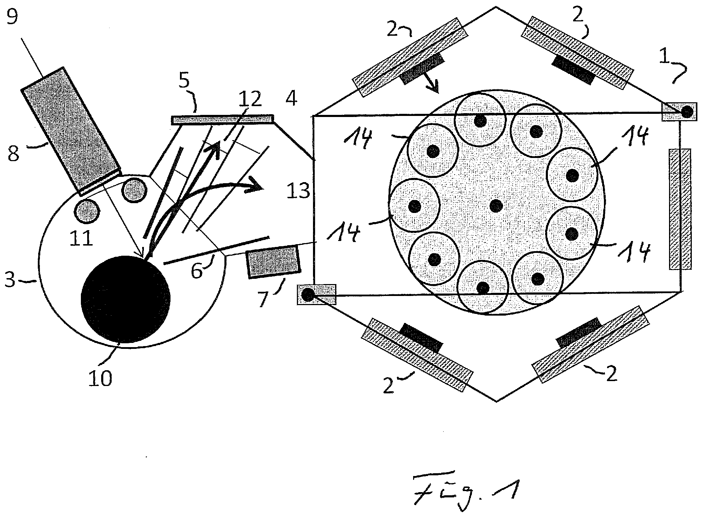

- Figur 1: in schematischer Form den Aufbau einer Vorrichtung die zur Ausbildung erfindungsgemäßer Verschleißschutzschichten geeignet ist.

Die Figur 1 zeigte eine Vakuumbeschichtungsanlage mit Vakuumkammer 1 in der eine Drehvorrichtung in der zu beschichtende Bauteile 14 fixiert und damit sowohl mit zweifacher als auch dreifacher Rotation beschichtet werden können. In der Vakuumkammer 1 sind bekannte Bogenentladungs- bzw. Sputterquellen 2 oder eine Kombination von beiden zum Plasmaätzen bzw. der Abscheidung einer dünnen Haftschicht vorhanden.

An die Vakuumkammer 1 ist eine Laser-Arc-Kammer 3 mit rotierender Graphitwalze als Kathode10 und einem Folienzug 11 zum Schutz des Lasereintrittsfensters vor Bedampfung angeflanscht. In Richtung der Vakuumkammer 1 ist ein Filtermodul 4, mit Servicetür und Innenaufbau der Absorber-AnodenAnordnung 5, 6 und seitlich angebauter Permanentmagnetenanordnung 7 vorhanden.

Desweiteren ist ein Scanner- und Fokussiersystem 8 mit Lasereintrittsfenster zur linearen Führung des Laserstrahls 9 über die volle Kathodenlänge an der Laser-Arc-Kammer 3 vorhanden. Mit dem Bezugszeichen 12 ist der Weg der aus dem mittels elektrischer Bogenentladung zwischen der Kathode 10 und der Anode 6 aus dem generierten Plasma selektierten größeren Partikeln in Richtung auf die Absorberelektrode 5 mit einem Pfeil verdeutlicht. Die elektrischen Bogenentladungen werden mittels des auslenkbaren Laserstrahls 9 auf der Oberfläche der Kathode 10, die aus 99,9 % Graphit besteht, gezündet. Dabei rotiert die Kathode 10 um eine Rotationsachse, die senkrecht zur Zeichnungsebene ausgerichtet ist und der Laserstrahl 9 wird entlang dieser Rotationsachse ausgelenkt. Dadurch kann ein gleichmäßiger Abtrag an Kathodenwerkstoff und gleichzeitig ein großer Bereich zur Beschichtung in der Vakuumkammer 1 genutzt werden.

Die Absorberelektrode 5 ist an ein elektrisch positives Potential angeschlossen. Sie ist mit mehreren elektrisch leitenden streifenförmigen Elementen, die in einem Abstand zueinander angeordnet sind, gebildet. Zwischen den streifenförmigen Elementen sind Spalte ausgebildet durch die größere Partikel geführt werden können.

Das Bezugszeichen13 verdeutlicht den Weg der abgelenkten Kohlenstoffionen des Plasmas zur Drehvorrichtung mit den zu beschichtenden Bauteilen 14 mit einem Pfeil.

Bei der der Ausbildung der Verschleißschutzschichten auf den Oberflächen der Bauteile 14 soll bevorzugt mit dreifacher Rotation beschichtet werden. Nach Evakuierung der Vakuumkammer 1 und Durchführung der Oberflächenreinigung und -aktivierung wird mittels Sputtern eine Cr-Haftschicht mit einer Dicke von ca. 0,1 µm abgeschieden.

Im Anschluss erfolgt die Abscheidung der ta-C-Schicht mit einer Dicke von ca. 1 µm. Aufgrund der gewählten Parameter der gepulsten Laser-Arc-Quelle, elektrischer Bogenstrom 1600 A, Pulslänge 350 µs bei einer Frequenz von 520 Hz in Kombination mit den an die Laser-Arc-Quelle angepassten Substrat-Bias-Parametern in einem Hochspannungsbereich von - 800 V bei einer Pulslänge von 350 µs und einem Niederspannungsbereich von - 100 V bei einer Pulslänge von 200 µs, werden sehr harte und glatte ta-C-Schichten mit einer hohen Haftung zur Bauteiloberfläche (Rc 1) abgeschieden. Es erfolgt eine Aufteilung des elektrischen Stromes, wobei 1100 A durch die Absorberelektrode 5 und 500 A durch die Anode 6 fließen. Die Anode 6 ist näher an der Kathode 10, als der in Richtung auf die Kathode 10 weisende Fuß der Absorberelektrode 5 angeordnet.

Die mittels Profilometer bestimmten Rauheitswerte, betragen: Rₐ im Mittel 0,09 µm, R_{z} im Mittel 1,0 µm und Rₚₖ im Mittel 0,28 µm. Die mittels Fischerscope ermittelte Mikrohärte der Verschleißschutzschicht betragt 7040 HV bzw. der mittels Lawave bestimmte E-Modul beträgt 740 GPa.

Im Schwing-Reib-Verschleiß-Tribometer mit Kolbenbolzenmodul der Firma Optimol Instruments Prüftechnik GmbH wurde ein Reibwert von 0,022 mit einem Einlauföl OW30 der Firma Castrol, als Schmiermittel bestimmt. Die Verschleißrate konnte im Vergleich zu herkömmlichen DLC-Schichten auf ca. 30 % reduziert werden.

## Patentansprüche

1. Verfahren zur Herstellung von Verschleißschutzschichten auf Oberflächen von Bauteilen von Verbrennungskraftmaschinen, die Reibverschleiß ausgesetzt sind, bei der ein Plasma mittels gepulst betriebener Laserstrahlung sequentiell gezündeter elektrischer Bogenentladungen unter Vakuumbedingungen, bei dem die elektrische Bogenentladung zwischen einer Anode (6) und einer als Kathode (10) aus Graphit betrieben werden, gebildet wird und ionisierte Teile des Plasma als Schicht, die aus zumindest annähernd wasserstofffreiem, tetraedisch amorphen (ta-C), bestehend aus einer Mischung von sp² und sp³ hybrisiertem Kohlenstoff gebildet wird, auf einer Oberfläche mindestens eines Bauteils (14) abgeschieden werden; wobei
das Plasma mittels einer Absorberelektrode (5) positiv geladene Ionen des Plasma in Richtung des mindestens einen Bauteils (14) umgelenkt werden und dabei an der Anode (6) und der Absorberelektrode (5) zumindest annähernd die gleiche elektrische Spannung anliegt, während die elektrischen Bogenentladungen betrieben werden, und durch die Absorberelektrode (5) ein elektrischer Strom von 1100 A ± 100 A und durch die Anode (6) ein elektrischer Strom von 500 A ± 100 A fließt, wenn elektrische Bogenentladungen gezündet worden sind und betrieben werden und
keine mechanische und/oder chemische Nachbearbeitung der beschichteten Oberfläche des mindestens einen Bauteils (14), die zu einer Glättung der Oberfläche führt, durchgeführt wird.

2. Verfahren nach einem der vorhergehenden Ansprüche, **dadurch gekennzeichnet, dass** das Plasma innerhalb einer Laser-Arc-Kammer (3) gebildet und in eine Vakuumkammer (1) in der das mindestens eine Bauteil (14) angeordnet ist, umgelenkt wird.

3. Verfahren nach einem der vorhergehenden Ansprüche, **dadurch gekennzeichnet, dass** mittels der Absorberelektrode (5) positiv geladenen Ionen des Plasma so umgelenkt werden, dass sie ausgehend von der Kathode (10) nicht auf direktem Weg auf die Oberfläche des mindestens einen Bauteils (14) auftreffen und sich Elektronen aus dem Plasma in Richtung Absorberelektrode (5) bewegen.

4. Verfahren nach einem der vorhergehenden Ansprüche, **dadurch gekennzeichnet**, das mit in der Vakuumkammer(1) angeordneter Bogenentladungs- oder Sputterquelle(n) (2) eine dünne Haftschicht auf dem mindestens einen Bauteil (14) abgeschieden wird.

5. Verfahren nach einem der vorhergehenden Ansprüche, **dadurch gekennzeichnet, dass** eine Absorberelektrode (5) mit mehreren Streifen eingesetzt wird, zwischen denen größere Tröpfchen oder Droplets abgeführt werden, so dass sie nicht auf die Oberfläche des mindestens einen Bauteils (14) auftreffen.

6. Verschleißschutzschicht, die auf Oberflächen von Bauteilen von Verbrennungskraftmaschinen, die Reibverschleiß ausgesetzt sind, mit einem Verfahren nach einem der vorhergehenden Ansprüche durch elektrischer Bogenentladung unter Vakuumbedingungen auf der jeweiligen Oberfläche ausgebildet worden sind, wobei die Verschleißschutzschicht aus zumindest annähernd wasserstofffreiem, tetraedisch amorphen (ta-C), bestehend aus einer Mischung von sp² und sp³ hybrisiertem Kohlenstoff, gebildet ist, und die Verschleißschutzschicht eine Mikrohärte von mindestens 3500 HV und einen arithmetischen Mittenrauwert Rₐ von 0,1 µm sowie eine reduzierte Spitzenhöhe Rₚₖ von maximal 0,35 µm aufweist, ohne dass eine mechanische und/oder chemische Oberflächenbearbeitung erfolgt ist, aufweist.

7. Verschleißschutzschicht nach Anspruch 6, die Verschleißschutzschicht eine Mikrohärte von mindestens 4000 HV aufweist.

8. Verschleißschutzschicht nach Anspruch 6 oder 7, **dadurch gekennzeichnet, dass** die Verschleißschutzschicht eine gemittelte Rautiefe R_{z} von maximal 1,0 µm aufweist.

9. Verschleißschutzschicht nach einem der Ansprüche 6 bis 8, **dadurch gekennzeichnet, dass** die Verschleißschutzschicht eine Mikrohärte von mindestens 5000 HV, bevorzugt von mindestens 5700 HV, besonders bevorzugt von mindestens 6000 HV aufweist.

10. Verschleißschutzschicht nach einem der Ansprüche 6 bis 9, **dadurch gekennzeichnet, dass** keine zusätzlichen chemischen Elemente enthalten sind.

## Claims

1. A method of producing wear-resistant layers on surfaces of components of internal combustion engines which are exposed to frictional wear, wherein a plasma is formed by means of pulse-operated laser radiation from sequentially ignited electrical arc discharges under vacuum conditions, wherein the electrical arc discharge is operated between an anode (6) and a cathode (10) of graphite and ionized parts of the plasma are deposited on a surface of at least one component (14) as a layer which is formed from at least approximately hydrogen-free tetrahedrally amorphous (ta-C) comprising a mixture of sp² and sp³ hybridized carbon, wherein
the plasma by means of an absorber electrode (5) positively charged ions of the plasma are deflected in the direction of the at least one component (14) and in this respect at least approximately the same electric voltage is applied at the anode (6) and at the absorber electrode (5) and while the electrical arc discharges are operated and an electric current of 1100 A ± 100 A flows through the absorber electrode (5) and an electric current of 500 A ± 100 A flows through the anode (6) when electrical arc discharges have been ignited and operated, and
no mechanical and/or chemical machine finishing of the coated surface of the at least one component (14) is carried out which leads to a smoothing of the surface.

2. A method in accordance with one of the preceding claims, **characterized in that** the plasma is formed within a laser arc chamber (3) and is deflected into a vacuum chamber (1) in which the at least one component (14) is arranged.

3. A method in accordance with one of the preceding claims, **characterized in that** positively charged ions of the plasma are deflected by means of the absorber electrode (5) such that they do not impact the surface of the at least one component (14) in a direct way starting from the cathode (10) and electrons move from the plasma in the direction of the absorber electrode (5).

4. A method in accordance with one of the preceding claims, **characterized in that** a thin adhesive layer is deposited on the at least one component (14) using arc discharge source(s) or sputter source(s) (2) arranged in the vacuum chamber (1).

5. A method in accordance with one of the preceding claims, **characterized in that** an absorber electrode (5) is used having a plurality of strips between which larger drops or droplets are led off so that they do not impact on the surface of the at least one component (14).

6. A wear-resistant layer which has been formed on surfaces of internal combustion engine components, which are exposed to frictional wear, using a method in accordance with one of the preceding claims by electrical arc discharges under vacuum conditions on the respective surface, wherein the wear-resistant layer is formed from at least approximately hydrogen-free tetrahedrally amorphous (ta-C) comprising a mixture of sp² and sp³ hybridized carbon,
and the wear-resistant layer has a microhardness of at least 3500 HV and an arithmetical mean roughness value Rₐ of 0.1 µm as well as a reduced peak height Rₚₖ of a maximum of 0.35 µm, without a mechanical, physical and/or chemical surface processing having taken place.

7. A wear-resistant layer in accordance with claim 6, which wear-resistant layer has a microhardness of at least 4000 HV.

8. A wear-resistant layer in accordance with claim 6 or claim 7, **characterized in that** the wear-resistant layer has a mean roughness depth R_{z} of a maximum of 1.0 µm.

9. A wear-resistant layer in accordance with one of the claims 6 to 8, **characterized in that** the wear-resistant layer has a microhardness of at least 5000 HV, preferably of at least 5700 HV, and particularly preferably of at least 6000 HV.

10. A wear-resistant layer in accordance with one of the claims 6 to 9, **characterized in that** no additional chemical elements are contained.

## Revendications

1. Procédé de réalisation de couches de protection contre l'usure sur des surfaces de composants de moteurs à combustion exposés à une usure par friction, dans lequel un plasma est formé à l'aide de décharges d'arcs électrique allumés de manière séquentielle au moyen d'un rayon laser fonctionnant par impulsions dans des conditions de vide, la décharge d'arc électrique ayant lieu entre une anode (6) et une cathode (10) en graphite et les parties ionisées du plasma étant déposées, sous la forme d'une couche constituée d'un carbone hybridé, au moins approximativement exempt d'hydrogène, amorphe de manière tétraédrique (ta-C), constitué d'un mélange de sp² et de sp³, sur une surface d'au moins un composant (14) ; les ions chargés positivement du plasma étant déviés, au moyen d'une électrode d'absorption (5), en direction de l'au moins un composant (14) et la même tension électrique, au moins approximativement, étant appliquée à l'anode (6) et à l'électrode d'absorption (5), pendant que les décharges d'arcs électriques ont lieu et un courant électrique de 1100 A ± 100 A circulant à travers l'électrode d'absorption (5) et un courant électrique de 500 A ± 100 A circulant à travers l'anode (6), lorsque les décharges d'arcs électriques ont été allumées et utilisées et
aucun post-traitement mécanique et/ou chimique de la surface revêtue de l'au moins un composant (14), qui permet un lissage de la surface, n'étant effectué.

2. Procédé selon l'une des revendications précédentes, **caractérisé en ce que** le plasma est formé à l'intérieur d'une chambre à arc laser (3) et est dévié vers une chambre à vide (1) dans laquelle l'au moins un composant (14) est disposé.

3. Procédé selon l'une des revendications précédentes, **caractérisé en ce que**, au moyen de l'électrode d'absorption (5), les ions chargés positivement du plasma sont déviés de façon à ce qu'ils n'arrivent pas directement de la cathode (10) à la surface de l'au moins un composant (14) et à ce que des électrons se déplacent hors du plasma en direction de l'électrode d'absorption (5).

4. Procédé selon l'une des revendications précédentes, **caractérisé en ce que**, avec des sources de décharges d'arcs ou de pulvérisation (2), disposées dans la chambre à vide (1), une mince couche adhérente est déposée sur l'au moins un composant (14).

5. Procédé selon l'une des revendications précédentes, **caractérisé en ce qu'**une électrode d'absorption (5) est utilisée, avec plusieurs bandes entre lesquelles des gouttelettes de grande taille sont évacuées, de façon à ce qu'elles n'arrivent pas sur la surface de l'au moins un composant (14).

6. Couche de protection contre l'usure, formée sur la surface de composants de moteurs à combustion exposés à une usure par friction, avec un procédé selon l'une des revendications précédentes, par décharge d'arc électrique dans des conditions de vide sur la surface concernée, la couche de protection contre l'usure étant constituée d'un carbone hybridé, au moins approximativement exempt d'hydrogène, amorphe de manière tétraédrique (ta-C), constitué d'un mélange de sp² et de sp³, et la couche de protection contre l'usure présentant une micro-dureté d'au moins 3500 HV et une rugosité moyenne arithmétique Rₐ de 0,1 µm ainsi qu'une hauteur de crête réduite Rₚₖ de 0,35 µm maximum, sans qu'un traitement de surface mécanique et/ou chimique ne soit effectué.

7. Couche de protection contre l'usure selon la revendication 6, la couche de protection contre l'usure présentant une micro-dureté d'au moins 4000 HV.

8. Couche de protection contre l'usure selon la revendication 6 ou 7, **caractérisée en ce que** la couche de protection contre l'usure présente une profondeur de rugosité moyenne de 1,0 µm maximum.

9. Couche de protection contre l'usure selon l'une des revendications 6 à 8, **caractérisée en ce que** la couche de protection contre l'usure présente une micro-dureté d'au moins 5000 HV, de préférence d'au moins 5700 HV, de préférence d'au moins 6000 HV.

10. Couche de protection contre l'usure selon l'une des revendications 6 à 9, **caractérisée en ce qu'**elle ne contient aucun élément chimique supplémentaire.
